# FASCICULE DE BREVET EUROPEEN

(11) **EP 2 409 554 B1**
(45) Date de publication et mention de la délivrance du brevet: **07.09.2016**
(21) Numéro de dépôt: 10708774.4
(22) Date de dépôt: 15.03.2010
(51) Int. Cl.: H05K 7/14

(54) **BOITIER,RACCORD ELECTRIQUE INCORPORANT CE BOITIER ET VEHICULE INCORPORANT CE RACCORD**
GEHÄUSE, ELEKTRISCHER ANSCHLUSS DAMIT UND FAHRZEUG MIT DEM ANSCHLUSS
HOUSING, ELECTRICAL CONNECTOR WITH SAID HOUSING AND VEHICLE WITH SAID CONNECTOR

(30) Priorité: 16.03.2009 FR 0901214
(43) Date de publication de la demande: 25.01.2012
(73) Titulaire: Peugeot Citroën Automobiles, 78140 Vélizy-Villacoublay (FR); Commissariat à l'Énergie Atomique et aux Énergies Alternatives, 75015 Paris (FR)
(72) Inventeur: DOLHAGARAY, Jean-Claude, F-91400 Saclay (FR); ROY, Francis, F-91940 Les Ulis (FR); CHATROUX, Daniel, F-38470 Têche (FR); MILLY, Roger, F-38290 Satolas et Bonce (FR); ROURE, Jimmy, F-69100 Villeurbanne (FR)
(74) Mandataire: Renous Chan, Véronique
(86) Numéro de dépôt international: PCT/EP2010/053309
(87) Numéro de publication internationale: WO 2010/106027

(56) Documents cités:
- US-A1- 2002 126 465
- US-B1- 6 359 331

## Description

L'invention concerne un boîtier, un raccord électrique réalisé à l'aide de ce boîtier et un véhicule équipé de ce raccord électrique.

Des boîtiers connus comportent :
- des composants électroniques,
- des parois isolant mécaniquement ces composants électroniques de l'extérieur,
- au moins un plot de connexion électrique disposé sur une face extérieure d'une de ces parois pour être raccordé électriquement à un ou plusieurs câbles ou un autre type de liaison électrique (barre, plaque, ...) extérieurs au boîtier, ce plot de connexion étant électriquement raccordé aux composants électroniques placés à l'intérieur du boîtier.

Dans les boîtiers connus, ce plot de connexion peut se présenter sous différentes formes :
- par exemple sous la forme d'une broche d'un connecteur. Un même connecteur peut suivant le besoin regrouper plusieurs plots de connexion isolés les uns des autres. Cette méthode exige un connecteur en deux parties, une partie fixée sur la face de la paroi du boîtier et une partie mobile solidaire du câble extérieur au boîtier. Ce principe a comme avantage d'entraîner un degré élevé de facilité et de fiabilité dans les opérations de connexions et de déconnexions. Par contre, il a comme inconvénient d'être très volumineux et très coûteux, surtout dans le cas d'applications à des courants élevés (supérieurs à une dizaine d'ampères).
- par exemple sous la forme d'une vis, d'un écrou et d'une embase métallique, en général en laiton ou en cuivre, permettant au courant électrique de traverser la paroi du boîtier.

L'embase métallique traverse de part en part la paroi, tout en étant par conception isolée électriquement de celle-ci. A l'intérieur du boîtier, elle est électriquement raccordée à un conducteur électrique qui raccorde électriquement cette vis aux composants électroniques. La vis fait saillie vers l'extérieur du boîtier perpendiculairement à la face extérieure. Elle est mécaniquement solidaire de l'embase métallique. Elle est en général métallique (conducteur électrique), reliée électriquement à l'embase métallique et également isolée de la paroi du boîtier.
L'embase métallique présente sur sa face extérieure une surface d'appui perpendiculaire à l'axe de la vis.

Le câble situé à l'extérieur du boîtier se termine par une cosse apte à être embrochée sur la vis du boîtier et venir s'appuyer sur cette surface d'appui. L'écrou permet alors de fixer la cosse sur la vis et d'établir le contact électrique entre la cosse et l'embase métallique donc avec les composants électroniques dans le boîtier. De tels boîtiers sont connus de US2002/0126465 A1 et US6359331B1.

La surface de contact entre la cosse et la surface d'appui doit être importante pour limiter la résistance électrique à l'interface entre ces deux éléments. Cela se traduit donc souvent par une connectique encombrante qui fait saillie bien au-delà de la face extérieure du boîtier.

Par ailleurs, un contact électrique avec la vis s'établit par l'intermédiaire de l'écrou, de la vis et de leurs filetages. Il existe donc également ce chemin de passage pour le courant. Cette résistance de câblage est fonction du couple de serrage, des états de surface de la vis et de l'écrou et de l'état de corrosion, Le contact électrique sera donc peu reproductible, et donc une source de panne ou de dysfonctionnement susceptible d'évoluer défavorablement dans le temps.

L'invention vise à remédier à au moins l'un de ces inconvénients en proposant un boîtier amélioré.

Elle a donc pour objet un boîtier conforme à la revendication 1.

Dans le boîtier ci-dessus, le plan extérieur (par exemple la connexion d'alimentation) constitue une surface de contact électrique du plot de connexion avec le câble extérieur sans que l'encombrement de la connectique dans une direction perpendiculaire à la face extérieure ait été augmenté. Cela permet donc de réaliser un plot de connexion dont l'encombrement dans une direction perpendiculaire à la face extérieure du boîtier est réduit.

De plus, la connectique ainsi réalisée est particulièrement simple et peu onéreuse.

Les modes de réalisation de ce boîtier, peuvent comporter une ou plusieurs des caracteristiques des revendications dépendantes.

Ces modes de réalisation du boîtier présentent en outre les avantages suivants :
- le positionnement d'un condensateur entre le plan d'alimentation et un plan de masse gravé sur la même carte de circuit imprimé permet de limiter les inductances parasites de câblage de ce condensateur, ce qui permet en fin de compte d'améliorer la filtration électromagnétique du mode commun ;
- utiliser un condensateur monté en surface permet de décroître encore plus les inductances parasites de câblage et donc d'améliorer encore plus la filtration électromagnétique du mode commun dans le but de contribuer au bon comportement du boîtier dans le domaine de la compatibilité électromagnétique (CEM);
- l'utilisation de plusieurs traverses conductrices raccordant les plans extérieur et intérieur permes d'assurer un passage de courant reproductible et fiable dans le temps qui est peu dépendant d'une force de serrage :
- l'utilisation de plan dont les surfaces sont supérieures au cm² permet d'obtenir des liaisons haute fréquence de faible impédance vers le ou les condensateurs de filtrage de mode commun ;
- l'utilisation d'un mécanisme de fixation amovible permet le montage et le démontage réversibles du câble extérieur.

L'invention a également pour objet un raccord électrique conforme à la revendication 7.

Les modes de réalisation de ce raccord peuvent comporter la caractéristique de la revendication 8.

Ce mode de réalisation du raccord électrique présente en outre l'avantage suivant :
l a disposition des cosses des câbles extérieurs les unes à côté des autres permet de décroître l'épaisseur de la connectique dans la direction perpendiculaire à la face extérieure de la carte de circuit imprimé.

L'invention a également pour objet un véhicule équipé du raccord électrique ci-dessus.

L'invention sera mieux comprise à la lecture de la description qui va suivre, donnée uniquement à titre d'exemple non limitatif et faite en se référant aux dessins sur lesquels :
- la Figure 1 est une illustration schématique d'un véhicule équipé d'un boîtier électronique de puissance,
- la Figure 2 est une illustration schématique et en coupe de la connectique du boîtier électronique de la Figure 1,
- les Figures 3 et 4 sont des illustrations en vue de dessus et en vue de dessous d'une carte de circuit imprimé utilisée dans la connectique de la Figure 2.

Dans ces figures, les mêmes références sont utilisées pour désigner les mêmes éléments.

Dans la suite de cette description, les caractéristiques et fonctions bien connues de l'homme du métier ne sont pas décrites en détails.

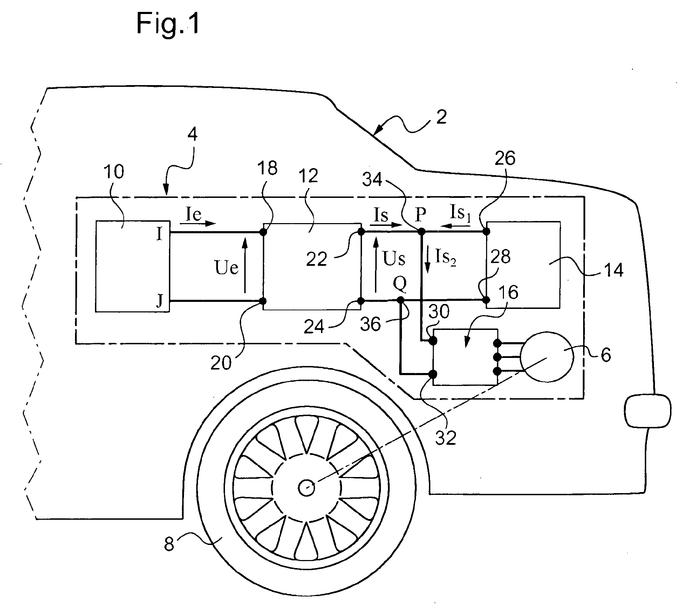

La Figure 1 représente un véhicule 2 tel qu'un véhicule automobile. Ce véhicule 2 est équipé d'un système 4 d'alimentation d'un moteur électrique 6 propre à entraîner en rotation des roues motrices du véhicule 2. Pour simplifier la Figure 1, seule une roue motrice 8 a été représentée.

Le système 4 comprend :
- une pile 10 à combustible propre à générer un courant d'intensité le sous une tension appelée Ue,
- un convertisseur continu - continu 12 dont des plots 18, 20 de connexion sont directement raccordés électriquement à la pile 10,
- une batterie 14 électrochimique dont des plots 26, 28 de connexion sont directement raccordés électriquement à des plots 22, 24 de connexion du convertisseur 12, et
- un onduleur 16 dont des plots 30, 32 de connexion sont également directement raccordés électriquement aux plots 22, 24 du convertisseur 12.

Par la suite, à défaut d'indication contraire, lorsqu'on indique que deux éléments sont raccordés entre eux, il s'agit d'un raccordement électrique.

De plus, lorsque l'on indique que ces deux éléments sont « directement » raccordés l'un à l'autre, cela signifie que la connexion électrique est réalisée sans passer par l'intermédiaire d'autres charges électriques. Typiquement, cela correspond à une liaison électrique directe réalisée à l'aide de conducteurs électriques dont la résistance linéique est très inférieure à 1Ω/m lorsqu'ils sont traversés par un courant continu.

Ici, un câble ou un conducteur est qualifié « de puissance » s'il est apte à véhiculer, sans se détériorer, un courant électrique de puissance. Un courant électrique de puissance est un courant dont l'intensité est, de préférence, supérieure à 25A ou 100A.

Les plots 22 et 24 sont également raccordés aux plots 30 et 32 par l'intermédiaire de dérivations électriques 34 et 36.

L'onduleur 16 génère une tension et un courant triphasé d'alimentation du moteur 6 à partir d'une tension continue Us.

Le convertisseur 12 génère la tension Us à partir de la tension Ue délivrée par la pile 10.

L'onduleur 16 est donc alimenté par la tension Us imposé par la batterie 14 et par les courants délivrés par le convertisseur 12 et par la batterie 14.

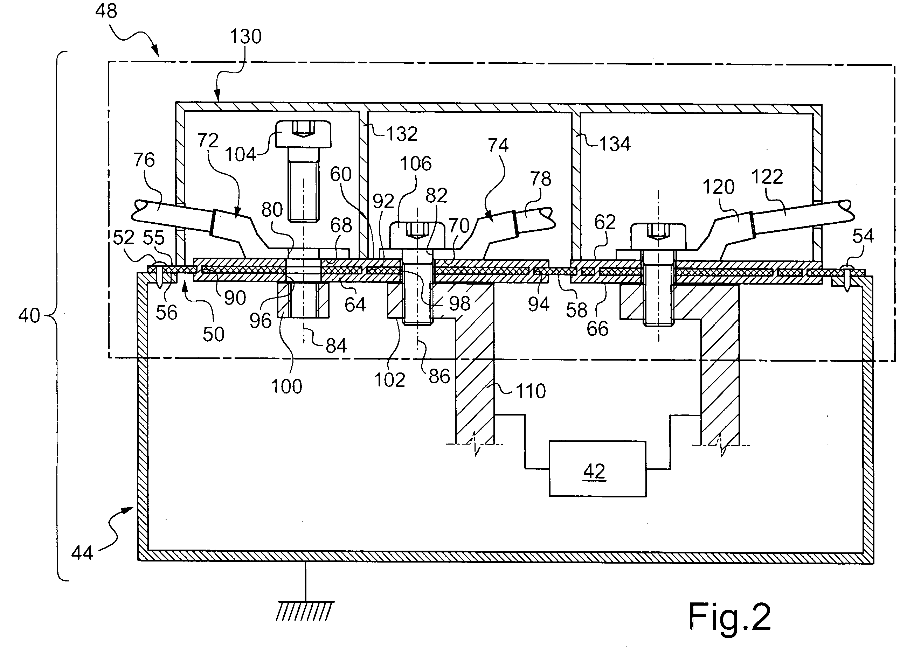

Le convertisseur 12 se présente sous la forme d'un boîtier 40 représenté plus en détail sur la Figure 2.

L'ensemble des composants électroniques de puissance nécessaires pour réaliser la conversion de la tension Ue et du courant le en la tension Us et le courant Is est logé à l'intérieur du boîtier 40. Pour simplifier l'illustration, ces composants électroniques de puissance sont représentés sous la forme d'un bloc 42.

Les contours extérieurs du boîtier 40 sont délimités par des parois 44. Les parois 44 entourent complètement les composants 42 pour les isoler mécaniquement de l'extérieur. Ici, ces parois 44 sont réalisées dans un matériau conducteur raccordé à la masse. Elles forment donc une cage de Faraday qui empêche la propagation des ondes électromagnétiques générées par la commutation des composants 42 à l'extérieur du boîtier 40.

Les parois 44 sont équipées d'une connectique 48. La connectique 48 comprend les plots de connexion 18, 20, 22 et 24.

Pour simplifier la Figure 2, seule la connectique correspondant aux plots 18, 22 est représentée en détail. La connectique pour réaliser les plots 20 et 24 de raccordement est similaire à ce qui est décrit en détail pour les plots 18, 22.

L'une des parois 44 présente une ouverture bouchée par une carte 50 de circuit imprimé. La carte 50 forme donc une partie de cette paroi et participe à l'isolation mécanique des composants 42 de l'extérieur. La carte 50 est fixée sans aucun degré de liberté sur le pourtour de l'ouverture. Par exemple, elle est fixée sur la paroi 44 à l'aide de vis 52, 54.

La carte 50 présente une face extérieure 55 tournée vers l'extérieur du boîtier et une face intérieure 56 tournée vers l'intérieur du boîtier. Des plans extérieurs et intérieurs de connexion électrique sont gravés, respectivement, sur les faces extérieure et intérieure 55 et 56. Typiquement, ces plans d'alimentation sont en cuivre. Ces plans sont des pistes conductrices dont la largeur et la longueur sont supérieures à 1 cm et, de préférence, à 2cm. Ici, chaque plan extérieur est de même dimension qu'un plan intérieur disposé en vis-à-vis de celui-ci mais sur l'autre face de la carte 50. Ces plans extérieurs et intérieurs sont séparés par une plaque 58 en matériau électriquement isolant.

A titre d'illustration, deux plans extérieurs 60 et 62 et les deux plans intérieurs 64 et 66 correspondantes sont représentés sur la figure 2. Les plans 60 et 64 appartiennent au plot de connexion 22. Les plans 62 et 66 appartiennent au plot 18 de connexion.

Le plan 60 est mis directement et simultanément en contact avec deux faces 68, 70, respectivement, de cosses 72, 74. Les cosses 72 et 74 forment les parties distales, respectivement, de câbles de puissance 76, 78. Le câble 76 raccorde le plot 22 au plot 26 de la batterie 14. Le câble 78 raccorde le plot 22 au plot 30 de l'onduleur 16.

Par exemple, les cosses 72 et 74 sont des cosses serties sur l'extrémité des câbles 76 et 78. Les cosses sont réalisées dans un matériau conducteur tel que du cuivre.

Chaque cosse 72, 74 comprend un trou traversant, respectivement 80, 82 s'étendant le long d'un axe, respectivement 84, 86, perpendiculaire aux faces 68 et 70. Ces trous 80 et 82 sont destinés à recevoir des vis de fixation.

Les cosses 72 et 74 sont disposées l'une à côté de l'autre de manière à ce que leurs faces respectives 68 et 70 soient directement et simultanément en appui sur le plan 60. Les faces 68 et 70 présentent une surface suffisamment importante pour permettre le passage du courant électrique de puissance sans causer de détérioration de ces cosses 72 et 74. Par exemple, à cet effet, les faces 68 et 70 présentent chacune une longueur de plus d'un centimètre sur une largeur de plus d'un centimètre.

La longueur et la largeur du plan 60 sont suffisantes pour recevoir, l'une à côté de l'autre, les cosses 72 et 74. La longueur et la largeur du plan 60 sont toutes les deux choisies pour définir une surface supérieure au cumul des surfaces des faces 68, 70.

Le plan 60 est raccordé au plan 64 par l'intermédiaire de traverses réalisées en matériau électriquement conducteur. Trois traverses 90, 92 et 94 sont représentées sur la Figure 2. Chaque traverse 90, 92 et 94 s'étend perpendiculairement aux faces 54 et 56. Ces traverses se prolongent du plan 60 jusqu'au plan 64. Ces traverses 90, 92 et 94 permettent d'assurer un passage de courant électrique reproductible et fiable dans le temps entre les composants électroniques 42 et le plan 60 sur lequel vient s'appuyer les cosses 72 et 74. En particulier, le passage de courant par les traverses ne dépend pas d'une force de serrage ou d'un état de surface.

Par exemple, ces traverses sont des trous métallisés. Le nombre de ces traverses ainsi que la section transversale de chacune de ces traverses sont choisis en fonction de l'intensité du courant de puissance qui doit passer du plan 60 au plan 64. Plus précisément, le nombre et la section des traverses sont choisis pour limiter l'échauffement.

La carte 50 est également équipée d'un mécanisme de fixation amovible, des cosses 72 et 74 sur le plan 60. A cet effet, des trous traversants 96, 98 sont réalisés au travers de la carte 50. Ces trous traversants 96 et 98 s'étendent, respectivement, le long des axes 84 et 86. Ils traversent de part en part l'épaisseur de la carte 50. Un écrou 100 est soudé sur le plan 64 autour de l'ouverture du trou 96. De façon similaire, un écrou 102 est soudé sur le plan 64 autour de l'ouverture du trou 98. Ces écrous 100 et 102 sont destinés à recevoir des vis, respectivement, 104 et 106. Dans leur position assemblée, les vis 104 et 106 traversent, respectivement, les trous 80, 96 et 82, 98 pour venir plaquer les faces 68 et 70 des cosses 72 et 74 contre le plan 60. Sur la Figure 2, seul la vis 106 est représentée dans sa position assemblée. A l'inverse, la vis 104 est représentée dans une position désassemblée. Dans la position désassemblée, la vis 104 n'a pas encore été introduite au travers des trous 80 et 96 ni visée à l'intérieur de l'écrou 100.

Les vis et les écrous sont ici réalisés dans un matériau électriquement conducteur tel que du cuivre ou de l'acier. Ainsi, le courant électrique de puissance amené ou distribué par les câbles extérieurs circule du plan 60 vers le plan 64 à la fois par l'intermédiaire des traverses 90, 92 et 94 mais également par l'intermédiaire des vis 104, 106 et des écrous 100 et 102.

De plus, ici, le boulon 102 est également soudé à un conducteur électrique 110 qui raccorde le plan 64 aux composants 42.

Le plot 22 ainsi réalisé remplit également la fonction de la dérivation 34. En effet, étant donné que les cosses 72 et 74 sont simultanément mises en contact avec le plan 60, celles-ci sont raccordées l'une à l'autre par l'intermédiaire de ce plan. Dès lors, l'utilisation d'une dérivation mécaniquement indépendante du boîtier 40 est évitée.

Le plan 62 est directement mis en contact électrique avec une cosse 120 formant l'extrémité distale d'un câble 122 de puissance raccordé à la pile 10. Le plot 18 utilisé pour raccorder le câble 122 aux composants 42 est identique au plot 22 à l'exception du fait que les plan 62 et 66 ne sont pas prévus pour recevoir deux cosses l'une à côté de l'autre. Ce plot n'est pas décrit ici en détail.

La connectique 48 comprend également un capot 130 de protection des plots de connexion et des cosses raccordées à ces plots. Ici, ce capot 130 comporte des cloisons internes 132 et 134 destinées à isoler électriquement les unes des autres les cosses de chacun des câbles de puissance. Ces cloisons permettent d'éviter l'apparition d'un court-circuit entre deux cosses en cas de mauvaise fixation de l'une des cosses sur la carte 50. A cet effet, la conception du capot 130 et des cloisons est telle qu'elle permet cette fonction d'isolation. Par exemple ils peuvent être réalisés dans un matériau électriquement isolant, ils peuvent aussi être réalisés dans un matériau métallique pour des raisons d'amélioration du comportement en CEM du système, mais dans ce cas la fonction isolation entre les cosses et entre les cosses et le capot est assurée par exemple par un capot doublé intérieurement par une couche isolante, ou bien un dimensionnement du capot suffisamment grand et robuste pour assurer cette isolation dans tous les cas. Le capot 130 est fixé sur la carte 50 ou sur la paroi 44 par tout moyen approprié.

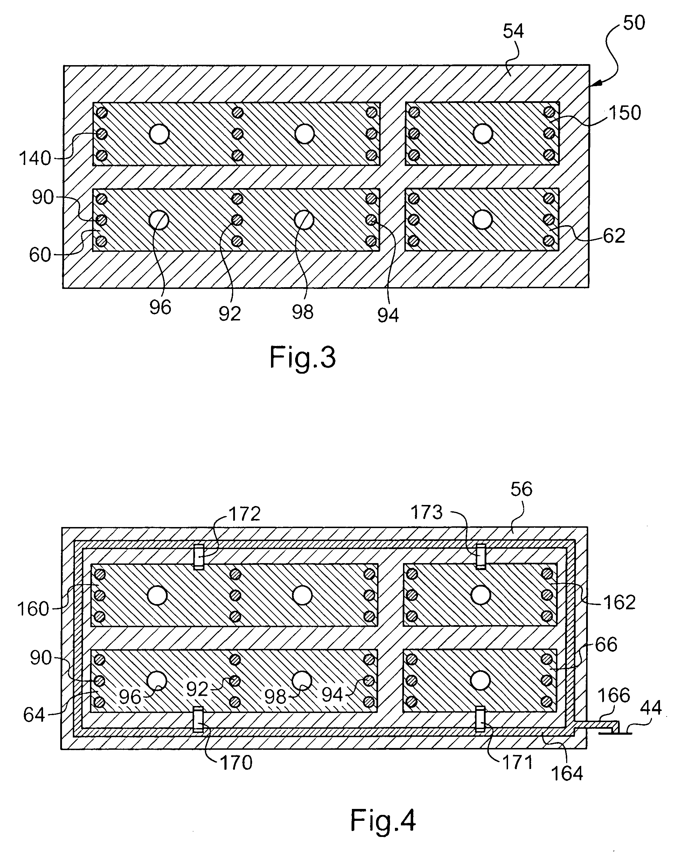

La Figure 3 représente la face extérieure 54 de la carte 50.

Sur cette figure, en plus des plans 60 et 62 déjà décrits, des plans 140 et 150 sont visibles. Par exemple, le plan 140 est utilisé pour la réalisation du plot 24. Le plan 150 est utilisé pour la réalisation du plot 20. Ces plots 20 et 24 sont similaires, respectivement, aux plots 18 et 22 et ne sont donc pas décrits ici en détail.

En dehors de ces plans 60, 62, 140 et 150, la face extérieure de la carte 50 est uniquement formée du matériau isolant 58.

Sur cette Figure 3, les cercles tels que les cercles 90, 92 et 94 symbolisent la position des différentes traverses qui relient les plans extérieurs aux plans intérieurs.

La Figure 4 représente la face intérieure 56 de la carte 50. Sur cette figure, en plus des plans 64 et 66, des plans 160 et 162 sont visibles. Ces plans 160 et 162 sont utilisés pour réaliser, respectivement, les plots 22 et 18. Ces plans sont de mêmes dimensions et disposés en vis-à-vis des plans visibles sur la face 54.

Les plans 160 et 162 remplissent les mêmes fonctions que les plans 64 et 66 et ne sont donc pas décrits ici plus en détail.

Contrairement à la face 54, la face 56 comprend, en plus des plans 64, 66, 160 et 162, un plan de masse 164 raccordé aux parois 44 par l'intermédiaire d'une connexion 166. Ce plan 164 est électriquement isolé des plans 64, 66, 160 et 162 par l'intermédiaire d'une bande du matériau isolant 58. Ce plan 164 passe à proximité de chacun des plans 64, 66, 160 et 162 tout en conservant par rapport à ces plans une distance d'isolation propre à éviter l'apparition d'un court-circuit direct entre l'un de ces plans 64, 66, 160 et 162 et le plan 164.

Des condensateurs 170 à 173 de filtrage de mode commun sont soudés entre les plans 64, 66, 160 et 162 et le plan 164 de manière à permettre le filtrage des perturbations électromagnétiques de fréquence supérieure ou égale à 10 MHz. Plus précisément, les condensateurs 170 à 173 sont soudés, d'une part entre le plan 164 et d'autre part, respectivement, entre les plans 64, 66, 160 et 162.

Ces condensateurs 170 à 173 sont des composants montés en surface (CMS) et sont donc pourvus d'extrémités métallisées directement soudées sur les plans conducteurs correspondants. Le positionnement de ces condensateurs 170 à 173 tel que décrit ici permet une amélioration de l'efficacité du filtrage électromagnétique de mode commun. En effet, les condensateurs sont positionnés très proches des connexions entre les câbles extérieurs et le plan de masse à l'aide d'un minimum de câblage, ce qui réduit les inductances parasites causées par ces câblages.

Plus précisément, les plans 64, 66, 160 et 162 sont de grande surface, c'est-à-dire que leur longueur et largeur respectives sont toutes deux supérieures au centimètre. Cela permet une liaison haute fréquence de faible impédance vers les condensateurs 170 à 173. On obtient ainsi une inductance parasite globale entre chacun des plans 64, 66, 160 et 162 et le plan 164 inférieure à 10 nH. Dès lors, les courants perturbateurs de mode commun sont dérivés vers les parois 44 du boîtier 40 qui fait fonction de cage de Faraday par ces condensateurs de découplage jusqu'à des fréquences supérieures à 10 MHz.

Ceci est un atout important par rapport aux solutions classiques de l'état de l'art qui consiste à souder un ou plusieurs condensateurs entre la vis et la paroi 44 du boîtier. Cette solution selon l'état de l'art est limitée par l'inductance parasite des pattes de connexions qui est de l'ordre de 10 nH par centimètre de patte. On observe classiquement qu'à partir de 10 MHz, le condensateur n'est plus apte à dériver correctement les courants parasites vers les parois 44 qui font office de cage de Faraday du fait de l'impédance parasite des pattes de liaison.

De nombreux autres modes de réalisation sont possibles. Par exemple, la carte 50 peut être remplacée par une carte de circuit imprimé comportant plus de deux couches dans lesquelles sont gravées des pistes. Une telle carte comporte au moins un plan extérieur en contact direct avec les cosses et au moins un plan intérieur en contact direct avec des conducteurs électriques situés à l'intérieur du boîtier 40. De plus, cette carte comporte une ou plusieurs couches intermédiaires logées entre les plans extérieurs et intérieurs. Des pistes conductrices sont gravées dans ces couches intermédiaires qui permettent de raccorder de façon souple et flexible les plans extérieurs et intérieurs.

A l'inverse, la carte 50 peut être remplacée par une carte de circuit imprimé ne comportant qu'une seule couche dans laquelle sont gravées toutes les pistes en matériau conducteur et, y compris, les plans d'alimentations. Dans ce mode de réalisation, le plan intérieur d'alimentation est omis. De préférence, un plan de masse, telle que le plan 164, est gravé dans cette unique couche et des condensateurs tels que les condensateurs 170 à 173 sont soudés comme décrit en regard de la Figure 4 pour filtrer les perturbations électromagnétiques de mode commun.

Les cosses des câbles extérieurs peuvent être fixées sur les plans extérieurs sans avoir recours à des écrous et des boulons. Par exemple, les cosses de câbles de puissance sont directement soudées sur les plans extérieurs.

Les câbles extérieurs peuvent être utilisés pour amener la tension d'alimentation ou tout autre potentiel souhaité. Généralement, il y a autant de plans extérieurs de connexion électrique que de potentiels différents dans l'ensemble des connexions à raccorder.

Il n'est pas nécessaire que les condensateurs de filtrage de mode commun soient montés en surface. Il peut également s'agir de condensateur équipé de pattes destinées à être soudées par soudage conventionnel.

Le capot de protection peut être réalisé à l'aide d'une gaine thermorétractable disposée sur l'ensemble de la face supérieure 54 de manière à mouler chacune des cosses ainsi que la face supérieure restant libre. Le capot de protection peut aussi être réalisé par moulage d'un matériau isolant sur les plans d'alimentation et les cosses de la face supérieure 54.

Le boîtier 40 peut être équipé de plusieurs cartes de circuit imprimé disposées sur différentes faces de ce boîtier.

Le conducteur électrique qui raccorde, à l'intérieur du boîtier 40, chaque plot aux composants 42 est un câble de puissance ou un jeu de barres capable de véhiculer le courant électrique de puissance à l'intérieur du boîtier.

En variante, le plan de masse est électriquement indépendant des parois 44 du boîtier 40.

En variante, le boîtier comprend uniquement des composants électroniques qui ne sont pas des composants électroniques de puissance.

Le boîtier décrit s'applique également au raccordement de câbles extérieurs uniquement adaptés pour véhiculer des courants de faibles intensités.

Ce qui a été décrit ci-dessus s'applique à tout boîtier comportant des composants électroniques isolés de l'extérieur par ce boîtier et destinés à être raccordés à des câbles extérieurs. Ainsi, il n'est pas nécessaire que ce boîtier soit utilisé dans un véhicule automobile. Il n'est pas non plus nécessaire que le boîtier soit le boîtier d'un convertisseur continu-continu. Par exemple, il peut s'agir d'un boîtier d'un onduleur. Il n'est pas non plus nécessaire que ce boîtier soit mis en oeuvre dans une configuration telle que celle décrite en regard de la Figure 1.

## Revendications

1. Boîtier électronique de puissance pour l'alimentation d'un moteur électrique de véhicule comprenant :
- des composants électroniques (42),
- des parois (44) isolant mécaniquement ces composants électroniques de l'extérieur,
- au moins un plot (18, 20, 22, 24) de connexion électrique disposé sur une face extérieure d'une de ces parois pour être raccordé électriquement à un câble extérieur au boîtier, ce plot de connexion étant électriquement raccordé aux composants électroniques (42) placés à l'intérieur du boîtier,
**caractérisé en ce que** ce plot de connexion comprend :
- une carte (50) de circuit imprimé formant une partie de la paroi (44) du boîtier et dont une face est exposée à l'extérieur du boîtier, et au moins un plan extérieur de connexion électrique (60, 62, 140, 150), gravé sur cette face, pour être directement mise en contact avec le câble extérieur, ce plan étant électriquement raccordé aux composants électroniques.
- un plan intérieur de connexion électrique (64, 66, 160, 162) gravé sur une face intérieure de la carte de circuit imprimé exposée à l'intérieur du boîtier, et
- plusieurs traverses (90, 92, 94) conductrices solidaires d'un côté du plan extérieur (60, 62) de connexion électrique et de l'autre côté du plan intérieur (64, 66) de connexion électrique pour les raccorder électriquement en permanence.

2. Boîtier selon la revendication 1, dans lequel le plot de connexion comprend:
- un plan de masse (164) gravé sur la carte de circuit imprimé, et
- au moins un condensateur (170-173) de filtrage de mode commun raccordé entre le plan de connexion électrique et ce plan de masse.

3. Boîtier selon la revendication 2, dans lequel le condensateur (170-173) est un condensateur monté en surface.

4. Boîtier selon l'une quelconque des revendications précédentes, dans lequel les plans de connexion électrique (60, 62, 64, 66, 140, 150, 160, 162) font au moins 1 cm de large sur au moins 1 cm de long.

5. Boîtier selon l'une quelconque des revendications précédentes, dans lequel le plot de connexion comprend un mécanisme (10, 102, 104, 106) de fixation amovible du câble extérieur sur le plan extérieur de connexion électrique.

6. Raccord électrique comprenant :
- au moins un câble extérieur (76, 78, 122) se terminant par une cosse (72, 74, 120) présentant une face de contact électrique,
- **caractérisé en ce que** le raccord comprend un boîtier (40) conforme à l'une quelconque des revendications précédentes, le plan extérieur (60, 62, 140, 150) de connexion électrique étant directement en appui sur la face de contact de la cosse.

7. Raccord selon la revendication précédente, dans lequel :
- le raccord comprend deux câbles extérieurs (76, 78) destinés à être électriquement raccordés au même plot de connexion, chaque câble extérieur se terminant par une cosse (72, 74) présentant une face de contact électrique, et
- la surface du plan extérieur (60) de connexion électrique de ce plot de connexion est suffisamment étendue pour que les faces de contact des cosses de ces deux câbles extérieurs soient directement et simultanément en appui l'une à côté de l'autre sur ce plan extérieur de connexion électrique.

8. Véhicule, **caractérisé en ce qu'**il comprend un raccord électrique conforme à la revendication 6 ou 7.

## Patentansprüche

1. Elektronisches Leistungsgehäuse zur Versorgung eines Kraftfahrzeugelektromotors, das Folgendes umfasst:
- elektronische Bauteile (42),
- Wände (44), die diese elektronischen Bauteile mechanisch von der Außenseite isolieren,
- mindestens einen elektrischen Verbindungkontakt (18, 20, 42, 24), der auf einer Außenseite einer dieser Wände angeordnet ist, um elektrisch an ein Kabel außerhalb des Gehäuses angeschlossen zu werden, wobei dieser elektrische Verbindungskontakt elektrisch an die elektronischen Bauteile (42), die im Inneren des Gehäuses platziert sind, angeschlossen ist,
**dadurch gekennzeichnet, dass** dieser Verbindungskontakt Folgendes umfasst:
- eine Leiterplattenkarte (50), die einen Teil der Wand (44) des Gehäuses bildet und von der eine Seite an dem Äußeren des Gehäuses exponiert ist, und mindestens eine äußere elektrische Anschlussfläche (60, 62, 140, 150), die auf dieser Seite graviert ist, um direkt mit dem externen Kabel in Kontakt gebracht zu werden, wobei diese Fläche elektrisch an elektronische Bauteile angeschlossen ist,
- eine innere elektrische Anschlussfläche (64, 66, 160, 162), die auf eine innere Seite der Leiterplattenkarte, die im Inneren des Gehäuses exponiert ist, graviert ist, und
- mehrere leitende Durchgänge (90, 92, 94), die fest mit einer Seite der äußeren elektrischen Anschlussfläche (60, 62) und der anderen Seite der inneren elektrischen Anschlussfläche (64, 66) verbunden sind, um sie ständig elektrisch anzuschließen.

2. Gehäuse nach Anspruch 1, **dadurch gekennzeichnet, dass** der Verbindungskontakt Folgendes umfasst:
- eine Massefläche (164), die auf die Leiterplattenkarte graviert ist, und
- mindestens einen Filterkondensator (170-173) zum Gleichtaktfiltern, der zwischen der elektrischen Anschlussfläche und dieser Massefläche angeschlossen ist.

3. Gehäuse nach Anspruch 2, wobei der Kondensator (170-173) ein auf der Oberfläche montierter Kondensator ist.

4. Gehäuse nach einem der vorhergehenden Ansprüche, wobei die elektrischen Anschlussflächen (60, 62, 64, 66, 140, 150, 160, 162) mindestens 1 cm breit und mindestens 1 cm lang sind.

5. Gehäuse nach einem der vorhergehenden Ansprüche, wobei der Verbindungskontakt einen Mechanismus (10, 102, 104, 106) zum abnehmbaren Befestigen des externen Kabels auf der externen elektrischen Anschlussfläche umfasst.

6. Elektrischer Anschluss, der Folgendes umfasst:
- mindestens ein externes Kabel (76, 78, 142), das in einem Kabelschuh (72, 74, 120) endet, der eine elektrische Kontaktfläche aufweist,
- **dadurch gekennzeichnet, dass** dieser elektrische Anschluss ein Gehäuse (40) nach einem der vorhergehenden Ansprüche umfasst, wobei die äußere elektrische Anschlussfläche (60, 62, 140, 150) direkt auf der Kontaktfläche des Kabelschuhs aufliegt.

7. Anschluss nach dem vorhergehenden Anspruch, wobei:
- der Anschluss zwei externe Kabel (76, 78) umfasst, die dazu bestimmt sind, elektrisch an denselben Verbindungskontakt angeschlossen zu sein, wobei jedes externe Kabel in einem Kabelschuh (72, 74) endet, der eine elektrische Kontaktfläche aufweist, und
- die Oberfläche der externen elektrischen Anschlussfläche (60) dieses Verbindungskontakts ausreichend ausgedehnt ist, damit die Kontaktflächen der Kabelschuhe dieser zwei externen Kabel direkt und gleichzeitig in Auflage nebeneinander auf dieser externen elektrischen Anschlussfläche sind.

8. Fahrzeug, **dadurch gekennzeichnet, dass** es einen elektrischen Anschluss nach dem Anspruch 6 oder 7 umfasst.

## Claims

1. An electronic power housing for the supply of an electric motor of a vehicle, including:
- electronic components (42),
- walls (44) insulating mechanically these electronic components from the exterior,
- at least one electrical connection pad (18, 20, 22, 24) arranged on an exterior face of these walls to be electrically coupled to a cable exterior to the housing, this connection pad being electrically coupled to the electronic components (42) placed inside the housing,
**characterized in that** this connection pad includes:
- a printed circuit board (50) forming a part of the wall (44) of the housing and one face of which is exposed to the exterior of the housing, and at least one exterior electrical connection plane (60, 62, 140, 150) etched on this face, to be directly put in contact with the exterior cable, this plane being electrically coupled to the electronic components,
- an interior electrical connection plane (64, 66, 160, 162) engraved on an interior face of the printed circuit board exposed to the interior of the housing, and
- several conductive cross-pieces (90, 92, 94) fixedly joined on one side to the exterior electrical connection plane (60, 62) and on the other side to the interior electrical connection plane (64, 66) to electrically couple them permanently.

2. The housing according to claim 1, in which the connection pad includes:
- a ground plane (164) engraved on the printed circuit board, and
- at least one common mode filtering capacitor (170-173) coupled between the electrical connection plane and this ground plane.

3. The housing according to claim 2, in which the capacitor (170-173) is a surface-mounted capacitor.

4. The housing according to any one of the preceding claims, in which the electrical connection planes (60, 62, 64, 66, 140, 150, 160, 162) have a width of at least 1 cm for a length of at least 1 cm.

5. The housing according to any one of the preceding claims, in which the connection pad includes a mechanism (10, 102, 104, 106) for the removable attachment of the exterior cable on the exterior electrical connection plane.

6. An electrical coupling including:
- at least one exterior cable (76, 78, 122) terminating by a lug (72, 74, 120) having an electrical contact face,
- **characterized in that** the coupling includes a housing (40) according to any one of the preceding claims, the exterior electrical connection plane (60, 62, 140, 150) being directly supported on the contact face of the lug.

7. The coupling according to the preceding claim, in which:
- the coupling includes two exterior cables (76, 78) intended to be electrically coupled to the same connection pad, each exterior cable terminating by a lug (72, 74) having an electrical contact face, and
- the surface of the exterior electrical connection plane (60) of this connection pad is sufficiently extensive so that the contact faces of the lugs of these two exterior cables are directly and simultaneously supported one beside the other on this exterior electrical connection plane.

8. A vehicle, **characterized in that** it includes an electrical coupling according to claim 6 or 7.
